# EUROPEAN PATENT APPLICATION

(11) **EP 1 903 680 A2**
(43) Date of publication of application: **26.03.2008**
(21) Application number: 07253675.8
(22) Date of filing: 17.09.2007
(51) Int. Cl.: H03K 19/018, H03K 19/0185

(54) **Voltage level converting circuit and display apparatus including the same**

(30) Priority: 19.09.2006 KR 20060090456
(71) Applicant: Samsung SDI Co., Ltd., Suwon-si, Gyeonggi-do (KR)
(72) Inventor: Kim, Do-Ik, Samsung SDI Co., Ltd., Suwon-si, Gyeonggi-do (KR)
(74) Representative: Mounteney, Simon James

(57) **Abstract**

A voltage level converting circuit includes a first transistor (Q1) including a first terminal coupled with a first terminal (31) supplying a first voltage, and a control terminal coupled with an input terminal (35), a second transistor (Q2) including a first terminal coupled with a second terminal (32) supplying a second voltage lower than the first voltage, and a control terminal coupled with the input terminal (35), a third transistor (Q3) including a first terminal coupled with a third terminal (33) supplying a third voltage higher than the first voltage, a second terminal coupled with an output terminal (36), and a control terminal coupled with a second terminal of the second transistor (Q2), and a fourth transistor (Q4) including a first terminal coupled with a fourth terminal (34) supplying a fourth voltage lower than the second voltage, a second terminal coupled with the output terminal (36), and a control terminal coupled with a second terminal of the first transistor (Q1).

## Description

### BACKGROUND OF THE INVENTION

### 1. Field of the Invention

The present invention relates to a voltage level converting circuit, and display apparatus including such a voltage level converting circuit. More particularly, but not exclusively, the invention relates to a voltage level converting circuit capable of achieving a fast rising and/or fast falling speed for a swinging output voltage and/or being manufactured at relatively lower cost, and display apparatus including such a voltage level converting circuit.

### 2. Description of the Related Art

Voltage level converting circuits are generally used in driver integrated circuits (ICs). For example, a display driver of a display panel may have several to hundreds of output channels. Each output channel may operate a switching operation that outputs a voltage level of a "high" or "low" level in a normal state, and transiently outputs a voltage level of a "low" or "high" opposite to the level of the output voltage level in the normal state, according to the voltage level of an input small-signal, and then again outputs the voltage level of the normal state.

However, conventional voltage level converting circuits generally employ analog switches including expensive semiconductor chips having a complex configuration, or relatively expensive types of OP-AMPs, and thus, are generally relatively expensive to manufacture. Further, the amplitude of a voltage swing output from a conventional voltage level converting circuit is generally not sufficient.

### SUMMARY OF THE INVENTION

The present invention sets out to provide a voltage level converting circuit and display apparatus including such a voltage level converting circuit, that substantially overcomes one or more of the problems due to the limitations and disadvantages of the

### related art.

Accordingly, a first aspect of the invention provides a voltage level converting circuit as set out in claim 1. Preferred features of the invention are as set out in claims 2 to 17. A second aspect of the invention provides a display apparatus as set out in claim 18.

### BRIEF DESCRIPTION OF THE DRAWINGS

Embodiments of the invention will now be described by way of example as reference to the accompanying drawings, in which:
FIG. 1 illustrates a circuit diagram of a voltage level converting circuit according to an embodiment of the present invention;
FIG. 2 illustrates a circuit diagram of a voltage level converting circuit according to another embodiment of the present invention;
FIG. 3 illustrates a circuit diagram of a voltage level converting circuit according to another embodiment of the present invention; and
FIG. 4 illustrates a circuit diagram of a voltage level converting circuit according to another embodiment of the present invention.

### DETAILED DESCRIPTION OF THE INVENTION

The present invention will now be described more fully hereinafter with reference to the accompanying drawings, in which embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout the specification.

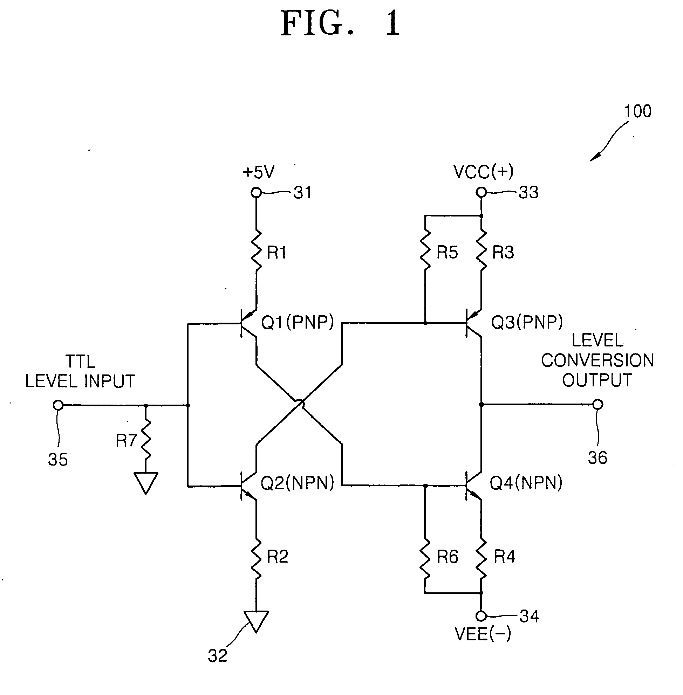

FIG. 1 illustrates a circuit diagram of a voltage level converting circuit 100 according to an embodiment of the present invention.

Referring to FIG. 1, the voltage level converting circuit 100 includes a first power supply terminal 31, a second power supply terminal 32, a third power supply terminal 33, a fourth power supply terminal 34, an input terminal 35, an output terminal 36, first through fourth switching transistors Q1 through Q4, and first through seventh resistors R1 through R7.

A first voltage is applied to the first power supply terminal 31, and a second voltage, which may be lower than the first voltage, is applied to the second power supply terminal 32. In this embodiment of the invention, the first voltage is 5 V and the second voltage is a ground voltage. Embodiments of the invention are not, however, limited thereto.

A high-level input signal including the first voltage or a low-level input signal including the second voltage may be applied to the input terminal 35. In some embodiments of the invention, e.g., a low voltage of a TTL-level (0-5 V) may be applied to the input terminal 35.

A third voltage +VCC, which may be higher than the first voltage, is applied to the third power supply terminal 33. A fourth voltage -VEE, which may be lower than the second voltage, is applied to the fourth power supply terminal 34.

A high-level output signal obtained by amplifying the third voltage +VCC, or a low-level output signal obtained by amplifying the fourth voltage -VEE is output to the output terminal 36.

In embodiments in which a general transistor is employed as the third switching transistor Q3, the third voltage +VCC may rise to a maximum voltage of about 50V. In embodiments in which a high voltage transistor is employed as the third switching transistor Q3, a voltage higher than 50V may be output.

The first switching transistor Q1 is a pnp bipolar transistor. The emitter of the first switching transistor Q1 is coupled with the first power supply terminal 31, the base of the first switching transistor Q1 is coupled with the input terminal 35, and the collector of the first switching transistor Q1 is coupled with the base of the fourth switching transistor Q4. If the first voltage of a high level, e.g., 5V, is applied to the input terminal 35, the first switching transistor Q1 is turned off. If the second voltage of a low level, e.g., 0V, is applied to the input terminal 35, the first switching transistor Q1 is turned on.

The first resistor R1 is coupled between the first power supply unit 31 and the emitter of the first switching transistor Q1. The first resistor R1 limits emitter current and the collector current of the first switching transistor Q1.

The second switching transistor Q2 is a npn bipolar transistor. The emitter of the second switching transistor Q2 is coupled with the second power supply terminal 32, the base of the second switching transistor Q2 is coupled with the input terminal 35, and the collector of the second switching transistor Q2 is coupled with the base of the third switching transistor Q3. When the first voltage of a high level, e.g., 5V, is applied to the input terminal 35, the second switching transistor Q2 is turned on. When the second voltage of a low level, e.g., 0V, is applied to the input terminal 35, the second switching transistor Q2 is turned off.

The second resistor R2 is coupled between the second power supply terminal 32 and the emitter of the second switching transistor Q2. The second resistor R2 limits emitter current and collector current of the second switching transistor Q2.

A first terminal of the seventh resistor R7 is coupled with the ground voltage, and a second terminal of the seventh resistor R7 is coupled with the base of the first switching transistor Q1 and the base of the second switching transistor Q2. When the input terminal 35 is open, the seventh resistor R7 allows application of a voltage of 0V.

The third switching transistor Q3 is a pnp bipolar transistor. The emitter of the third switching transistor Q3 is coupled with the third power supply terminal 33, the collector of the third switching transistor Q3 is coupled with the output terminal 36, and the base of the third switching transistor Q3 is coupled with the collector of the second switching transistor Q2. When the second switching transistor Q2 is turned on, the third switching transistor Q3 is also turned on.

The third resistor R3 is coupled between the third power supply terminal 33 and the emitter of the third switching transistor Q3. The third resistor R3 limits emitter current and collector current of the third switching transistor Q3.

A first terminal of the fifth resistor R5 is coupled with the third power supply terminal 33, and a second terminal of the fifth resistor R5 is coupled with the base of the third switching transistor Q3 and the collector of the second switching transistor Q2. The fifth resistor R5 provides a constant and/or substantially constant voltage to the base of the third switching transistor Q3 and the collector of the second switching transistor Q2. When the second switching transistor Q2 is turned on, a voltage obtained by subtracting a voltage drop due to the fifth resistor R5 from the third voltage +VCC is provided to the base of the third switching transistor Q3 and the collector of the second switching transistor Q2, and accordingly the third switching transistor Q3 is also turned on. In order to turn on the third switching transistor Q3, the fifth resistor R5 has a resistance greater than that of the third resistor R3.

The fourth switching transistor Q4 is a npn bipolar transistor. The emitter of the fourth switching transistor Q4 is coupled with the fourth power supply terminal 34, a collector of the fourth switching transistor Q4 is coupled with the output terminal 36, and the base of the fourth switching transistor Q4 is coupled with the collector of the first switching transistor Q1. When the first switching transistor Q1 is turned on, the fourth switching transistor Q4 is also turned on.

The fourth resistor R4 is coupled with the fourth power supply terminal 34 and the emitter of the fourth switching transistor Q4. The fourth resistor R4 limits emitter current and collector current of the fourth switching transistor Q4.

A first terminal of the sixth resistor R6 is coupled with the fourth power supply terminal 34, and a second terminal of the sixth resistor R6 is coupled with the base of the fourth switching transistor Q4 and the collector of the first switching transistor Q1. The sixth resistor R6 provides a constant or substantially constant voltage to the base of the fourth switching transistor Q4 and the collector of the first switching transistor Q1. When the first switching transistor Q1 is turned on, a voltage obtained by adding a voltage increase value due to the sixth resistor R6 to the fourth voltage -VEE is provided to the base of the fourth switching transistor Q4 and the collector of the first switching transistor Q1. Accordingly, the fourth switching transistor Q4 is be turned on. In order to turn on the fourth switching transistor Q4, the sixth resistor R6 has a resistance greater than that of the fourth resistor R4.

Hereinafter, operation of the voltage level converting circuit 100 of FIG. 1 will be described in detail.

A low voltage of a TTL-level (0-5 V) can applied to the input terminal 35. In such cases, a high-level input signal including a first voltage, e.g., 5V, or a low-level input signal including a second voltage, e.g., 0V, may be applied to the input terminal 35.

When the low-level input signal is applied to the input terminal 35, the first switching transistor Q1 is turned on and the second switching transistor Q2 is turned off. When the first switching transistor Q1 is turned on, a constant and/or substantially constant voltage is applied to the collector of the first switching transistor Q1 and the base of the fourth switching transistor Q4. Accordingly, the fourth switching transistor Q4 is turned on and the fourth voltage -VEE is output through the output terminal 36.

When the high-level input signal is applied to the input terminal 35, the first switching transistor Q1 is turned off and the second switching transistor Q2 is turned on. When the second switching transistor Q2 is turned on, a constant and/or substantially constant voltage is applied to the collector of the second switching transistor Q2 and the base of the third switching transistor Q3. Accordingly, the third switching transistor Q3 is turned on and the third voltage +VCC is output through the output terminal 36.

If a general transistor is employed as the third switching transistor Q3, the third voltage +VCC may rise to a maximum voltage of about 50V, and thus, an output voltage swing may be increased to a relatively high voltage of about 50V. If a high voltage transistor is employed as the third switching transistor Q3, a voltage higher than 50V may be output, and thus, the output voltage swing may be increased to a voltage higher than about 50V.

Because the output voltage swings between the third voltage +VCC and the fourth voltage -VEE, it is possible to vary the output voltage swing by changing the third voltage +VCC and the fourth voltage -VEE.

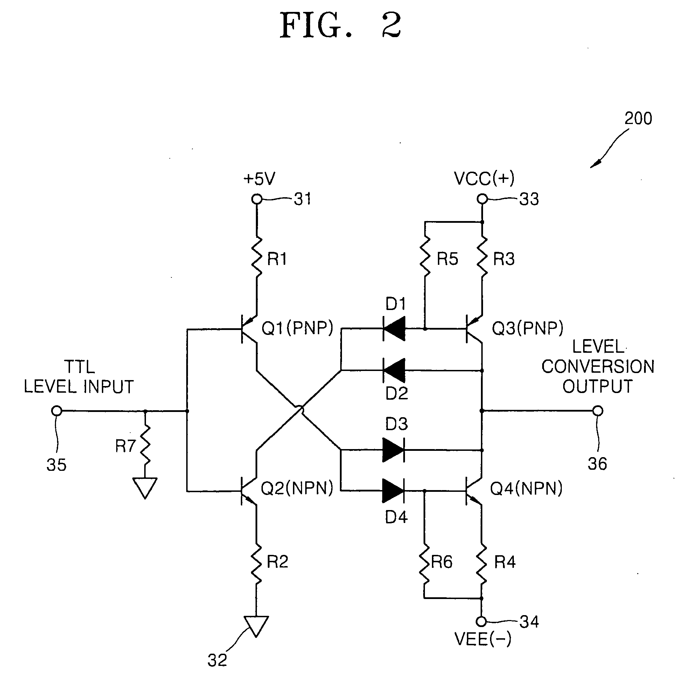

FIG. 2 illustrates a circuit diagram of a voltage level converting circuit 200 according to another embodiment of the present invention.

Hereinafter, in general, only differences between the voltage level converting circuit 200 illustrated in FIG. 2 and the voltage level converting circuit 100 illustrated in FIG. 1 will be described.

Referring to FIG. 2, as compared to the voltage level converting circuit 100 of FIG. 1, the voltage level converting circuit 200 further includes first through fourth diodes D1 through D4.

The cathode of the first diode D 1 is coupled with the collector of the second bipolar transistor Q2, and an anode of the first diode D1 is coupled with the base of the third bipolar transistor Q3. The cathode of the second diode D2 is coupled with the collector of the second bipolar transistor Q2, and the anode of the second diode D2 is coupled with the collector of the third bipolar transistor Q3.

The anode of the third diode D3 is coupled with the collector of the first bipolar transistor Q1, and the cathode of the third diode D3 is coupled with the collector of the fourth bipolar transistor Q4. An anode of the fourth diode D4 is coupled with the collector of the first bipolar transistor Q1 and the cathode of the fourth bipolar transistor Q4 is coupled with the base of the fourth bipolar transistor Q4.

When the first through fourth diodes D1 through D4 are coupled as illustrated in FIG. 2, switching speeds of the third bipolar transistor Q3 and the fourth bipolar transistor Q4 can be significantly improved.

More particularly, e.g., before an emitter-base voltage of the third bipolar transistor Q3 enters a saturation area, the second diode D2 is switched on so as to bypass the base current of the third bipolar transistor Q3 to the collector of the third bipolar transistor Q3. As a result, the third bipolar transistor Q3 is prevented from operating in the saturation area, and accordingly, the switching speed of the third bipolar transistor Q3 can be improved.

Likewise, before an emitter-base voltage of the fourth bipolar transistor Q4 enters the saturation area, the third diode D3 is switched on so as to bypass the base current of the fourth bipolar transistor Q4 to the collector of the fourth bipolar transistor Q4. As a result, the fourth bipolar transistor Q4 is prevented from operating in the saturation area, and accordingly, the switching speed of the fourth bipolar transistor Q4 can be improved.

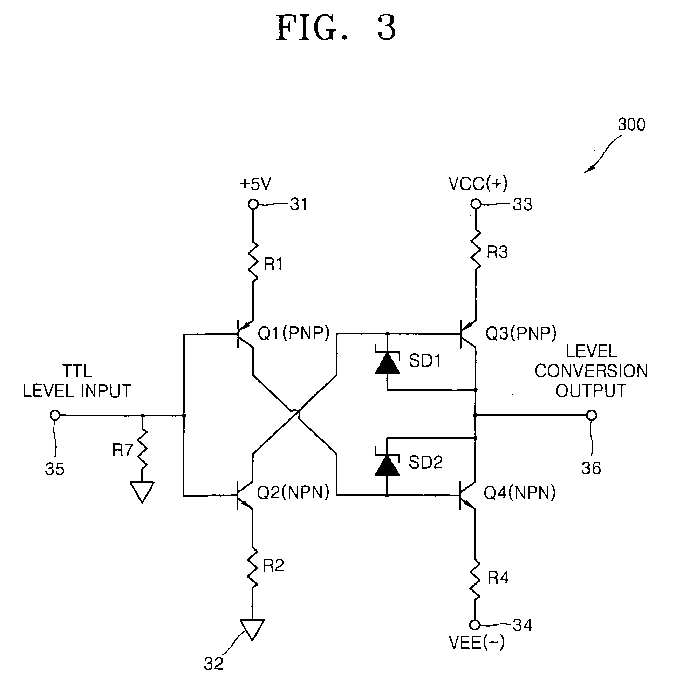

FIG. 3 illustrates a circuit diagram of voltage level converting circuit 300 according to another embodiment of the present invention.

Hereinafter, in general, only differences between the voltage level converting circuit 300 illustrated in FIG. 3 and the voltage level converting circuit 100 illustrated in FIG. 1 will be described.

Referring to FIG. 3, as compared to the voltage level converting circuit 100 of FIG. 1, the voltage level converting circuit 300 includes a first schottky diode SD1 and a second schottky diode SD2, and does not include the fifth resistor R5 and the sixth resistor R6.

The cathode of the first schottky diode SD1 is coupled with the base of the third bipolar transistor Q3, and the anode of the first schottky diode SD1 is coupled with the collector of the third bipolar transistor Q3.

The anode of the second schottky diode SD2 is coupled with the base of the fourth bipolar transistor Q4, and the cathode of the second schottky diode SD2 is coupled with the collector of the fourth bipolar transistor Q4.

When the first schottky diode SD 1 and the second schottky diode SD2 are coupled as illustrated in FIG. 3, like the case where the first through fourth diodes D through D4 are coupled as illustrated in FIG. 2, the switching speeds of the third bipolar transistor Q3 and the fourth bipolar transistor Q4 can be improved.

Before an emitter-base voltage of the third bipolar transistor Q3 enters the saturation area, the first schottky diode SD 1 is switched on so as to bypass the base current of the third bipolar transistor Q3 to the collector of the third bipolar transistor Q3. As a result, the third bipolar transistor Q3 is prevented from operating in the saturation area, and accordingly, the switching speed of the third bipolar transistor Q3 can be improved.

Likewise, before an emitter-base voltage of the fourth bipolar transistor Q4 enters the saturation area, the second schottky diode SD2 is switched on so as to bypass the base current of the fourth bipolar transistor Q4 to the collector of the fourth bipolar transistor Q4. As a result, the fourth bipolar transistor Q4 is prevented from operating in the saturation area, and accordingly, the switching speed of the fourth bipolar transistor Q4 can be improved.

When the first through fourth diodes D 1 through D4 are coupled as illustrated in FIG. 2, or the first schottky diode SD1 and the second schottky diode SD2 are coupled as illustrated in FIG. 3, a rising time period and a falling time period of an output signal can be reduced to a maximum of about 100 ns. Accordingly, the exemplary voltage level converting circuits 200, 300 illustrated in FIGS. 2 and 3 can perform high-speed switching operations.

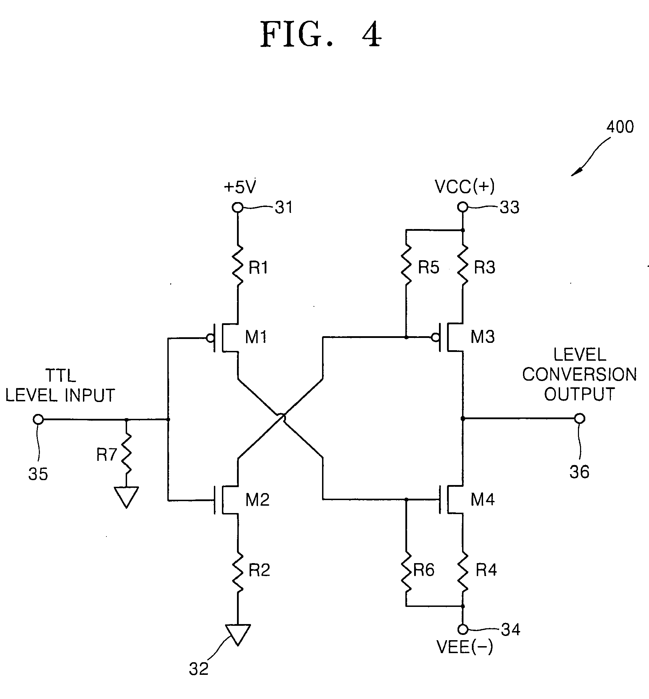

FIG. 4 illustrates a circuit diagram of voltage level converting circuit 400 according to another embodiment of the present invention.

Hereinafter, in general, only differences between the voltage level converting circuit 400 illustrated in FIG. 4 and the voltage level converting circuit 100 illustrated in FIG. 1 will be described.

Referring to FIG. 4, as compared to the voltage level converting circuit 100 of FIG. 1, the voltage level converting circuit 400 employs, first through fourth MOS transistors M1 through M4, instead of, pnp or npn bipolar transistors, for the first through fourth switching transistors Q1 through Q4.

The first switching transistor M1 is a PMOS transistor. A first terminal of the first switching transistor M1 is coupled with the first power supply terminal 31 via the first resistor R1, the gate of the first switching transistor M1 is coupled with the input terminal 35, and a second terminal of the first switching transistor M1 is coupled with the gate of the fourth switching transistor M4.

The second switching transistor M2 is a NMOS transistor. A first terminal of the second switching transistor M2 is coupled with the second power supply terminal 32 via the second resistor R2, the gate of the second switching transistor M2 is coupled with the input terminal 35, and a second terminal of the second switching transistor M2 is coupled with the gate of the third switching transistor M3.

The third switching transistor M3 is a PMOS transistor. A first terminal of the third switching transistor M3 is coupled with the third power supply unit 33 via the third resistor R3, a second terminal of the third switching transistor M3 is coupled with the output terminal 36, and the gate of the third switching transistor M3 is coupled with the second terminal of the second switching transistor M2.

The fourth switching transistor M4 is an NMOS transistor. A first terminal of the fourth switching transistor M4 is coupled with the fourth power supply terminal 34 via the fourth resistor R4, a second terminal of the fourth switching transistor M4 is coupled with the output terminal 36, and the gate of the fourth switching transistor M4 is coupled with the second terminal of the first switching transistor M1.

The first and second terminals of each of the first through fourth switching transistors M1 through M4 can be a source and a drain, respectively, however, embodiments of the present invention are not limited thereto.

Embodiments of the invention may provide voltage level converting circuits capable of obtaining a voltage swing output with a large amplitude, as compared to conventional voltage level converting circuits including analog switches and OP-AMPs.

Embodiments of the invention may separately provide voltage level converting circuits employing a switching speed enhancement device that allows a bipolar transistor to operate in a non-saturation area.

Embodiments of the invention may separately provide voltage level converting circuits capable of having faster and/or improved rising speed(s) and falling speed(s) of a voltage swing output therefrom.

Embodiments of the invention may separately provide voltage level converting circuits employing relatively inexpensive devices, and thus, capable of being manufactured at relatively lower cost than conventional voltage level converting circuits.

It will be understood that, although the terms first, second, etc. may be used herein to describe various elements, these elements should not be limited by these terms. These terms are used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (*e.g*., "between" versus "directly between," "adjacent" versus "directly adjacent," etc.).

Embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1. A voltage level converting circuit, comprising:
a first switching transistor including a first terminal coupled with a first power supply terminal adapted to receive a first voltage, and a control terminal coupled with an input terminal;
a second switching transistor including a first terminal coupled with a second power supply terminal adapted to receive a second voltage lower than the first voltage, and a control terminal coupled with the input terminal;
a third switching transistor including a first terminal coupled with a third power supply terminal adapted to receive a third voltage higher than the first voltage, a second terminal coupled with an output terminal, and a control terminal coupled with a second terminal of the second switching transistor; and
a fourth switching transistor including a first terminal coupled with a fourth power supply terminal adapted to receive a fourth voltage lower than the second voltage, a second terminal coupled with the output terminal, and a control terminal coupled with a second terminal of the first switching transistor.

2. A circuit as claimed in claim 1, adapted to operate in such a manner that, when a high-level input signal including the first voltage or a low-level input signal including the second voltage is applied to the input terminal, it generates a high-level output signal by amplifying the third voltage or it generates a low-level output signal by amplifying the fourth voltage, and it outputs the high-level or low-level output signal through the output terminal.

3. A circuit as claimed in claim 1 or 2, further comprising a first resistor coupled with the first power supply terminal and the first terminal of the first switching transistor, a second resistor coupled with the second power supply terminal and the first terminal of the second switching transistor, a third resistor coupled with the third power supply terminal and the first terminal of the third switching transistor, and a fourth resistor coupled with the fourth power supply terminal and the first terminal of the fourth switching transistor.

4. A circuit as claimed in claim 3, further comprising at least one of a fifth resistor coupled with the third power supply terminal and the control terminal of the third switching transistor, and a sixth resistor coupled with the fourth power supply terminal and the control terminal of the fourth switching transistor.

5. A circuit as claimed in claim 4, wherein the fifth resistor has a larger resistance than the third resistor, and the sixth resistor has a larger resistance than the fourth resistor.

6. A circuit as claimed in any preceding claim, further comprising a seventh resistor coupled with the input terminal and a ground voltage.

7. A circuit as claimed in any preceding claim, wherein the second voltage is a ground voltage.

8. A circuit as claimed in any preceding claim, wherein the first to fourth switching transistors are bipolar transistors.

9. A circuit as claimed in claim 8, wherein the first and third switching transistors are pnp bipolar transistors, and the second and fourth switching transistors are npn bipolar transistors.

10. A circuit as claimed in claim 8 or 9, wherein the first terminal of each of the first through fourth switching transistors is an emitter, the second terminal of each of the first through fourth switching transistors is a collector, and the control terminal of each of the first through fourth switching transistors is a base.

11. A circuit as claimed in claim 8, 9 or 10, further comprising switching speed enhancement devices respectively coupled with the third bipolar transistor and the fourth bipolar transistor.

12. A circuit as claimed in claim 10, further comprising:
a first diode including a cathode coupled with the collector of the second bipolar transistor, and an anode coupled with the base of the third bipolar transistor;
a second diode including a cathode coupled with the collector of the second bipolar transistor, and an anode coupled with the collector of the third bipolar transistor;
a third diode including an anode coupled with the collector of the first bipolar transistor, and a cathode coupled with the collector of the fourth bipolar transistor; and
a fourth diode including an anode coupled with the collector of the first bipolar transistor, and a cathode coupled with the base of the fourth bipolar transistor.

13. A circuit as claimed in claim 10, but not dependent on claim 4 or 5 further comprising:
a first schottky diode including a cathode coupled with the base of the third bipolar transistor, and an anode coupled with the collector of the third bipolar transistor; and
a second schottky diode including an anode coupled with the base of the fourth bipolar transistor, and a cathode coupled with the collector of the fourth bipolar transistor.

14. A circuit as claimed in any of claims 1 to 7, wherein the first through fourth transistors are MOS transistors.

15. A circuit as claimed in claim 14, wherein the first and third switching transistors are PMOS transistors, and the second and fourth switching transistors are NMOS transistors.

16. A circuit as claimed in claim 14 or 15, wherein the first terminal of each of the first through fourth transistors is a source, the second terminal of each of the first through fourth transistors is a drain, and the control terminal of each of the first through fourth transistors is a gate.

17. A circuit as claimed in claim 1, wherein at least the third switching transistor is a high voltage transistor.

18. A display apparatus comprising a display unit including a plurality of pixels, and a driver unit including a voltage level converting circuit in order to drive the plurality of pixels, wherein the voltage level converting circuit is as defined in any preceding claim.
